# EUROPÄISCHE PATENTANMELDUNG

(11) **EP 4 456 684 A1**
(43) Veröffentlichungstag der Anmeldung: **30.10.2024**
(21) Anmeldenummer: 23169851.5
(22) Anmeldetag: 25.04.2023
(51) Int. Cl.: H05K 5/02, B65G 43/10, H01R 12/67

(54) **MOTORSTEUERUNGSVORRICHTUNG ZUM ANTRIEB EINER FÖRDERVORRICHTUNG**

(71) Anmelder: Murrelektronik GmbH, 71570 Oppenweiler (DE)
(72) Erfinder: Waser, Bernd, 71570 Oppenweiler (DE); Wolff, Ingo, 71570 Oppenweiler (DE)
(74) Vertreter: Prinz & Partner mbB

(57) **Zusammenfassung**

Es wird eine Motorsteuerungsvorrichtung (10) für wenigstens einen Antrieb einer Fördervorrichtung (32) gezeigt. Dabei hat die Motorsteuerungsvorrichtung (10) eine Niederspannungsversorgungsschnittstelle (22) zur direkten Anbindung der Motorsteuerungsvorrichtung (10) an eine Niederspannungsleitung (8). Des Weiteren ist die Niederspannungsvorrichtungsschnittstelle (22) mittels der Durchdringungstechnik ausgebildet, sodass die Anbindung an die Niederspannungsleitung (8) unterbrechungsfrei erfolgt. Ferner ist ein System (6) beschrieben.

## Beschreibung

Die Erfindung betrifft eine Motorsteuerungsvorrichtung für wenigstens einen Antrieb einer Fördervorrichtung. Des Weiteren betrifft die Erfindung ein System mit einer Niederspannungsleitung und wenigstens einer Motorsteuerungsvorrichtung für wenigstens einen Antrieb einer Fördervorrichtung.

Auf dem Gebiet der Intralogistik sind als Rollenmotor ausgebildete Antriebe bekannt, die über eine Motorsteuerungsvorrichtung, auch als Motor-Controller bezeichnet, angesteuert werden. Typischerweise werden diese Antriebe über Schutzkleinspannung oder Niederspannung versorgt. Besonders bei Fördervorrichtungen, mit denen Gegenstände mit einem geringen Gewicht transportiert werden, kommen häufig Schutzkleinspannungen zum Einsatz, da diese bei der Installation weniger aufwendig sind. Niederspannungsantriebe kommen erst dann zum Einsatz, wenn höhere Leistungen zum Transport der Gegenstände benötigt werden.

Zumeist wird die Versorgungsleitung bei der Installation der Motorsteuerungsvorrichtung unterbrochen, sodass diese durch die Motorsteuerungsvorrichtung geführt werden kann. Diese Unterbrechung führt zu zusätzlichen Widerständen, nämlich aufgrund der Klemmung und Führung der Leistung durch die Motorsteuerungsvorrichtung, wodurch die maximale Ausdehnung der Fördervorrichtung stark beschränkt wird.

Auch ist es bekannt, die Antriebe sowie die Motorsteuerungsvorrichtung mit einer Nennspannung von 24 Volt Gleichspannung (VDC) oder 48 Volt Gleichspannung (VDC) zu versorgen. Dies hat jedoch zur Folge, dass nur wenige Antriebe an einem Versorgungsstrang vorgesehen werden können, sodass die Anzahl der benötigten Leitungen entsprechend hoch ist, was zu hohen Installationskosten führt. Bei einer Kleinspannungsversorgung von 24 VDC und 30 W Antrieben hat dies beispielsweise zur Folge, dass maximal 11 bzw. 18 Antriebe, bei einer typischen Verdrahtung mit 1,5 mm² bzw. 2,5 mm² Leitungen, versorgt werden können. Da eine Motorsteuerungsvorrichtung typischerweise vier Antriebe ansteuern kann, muss nach drei bis fünf Motorsteuerungsvorrichtungen bereits eine neue Spannungsversorgung erfolgen. Je größer die Fördervorrichtung ist, desto mehr Versorgungsstränge werden benötigt, was insbesondere dazu führen kann, dass zahlreiche Leitungen parallel verlegt werden müssen.

Die Aufgabe der Erfindung ist es, eine hohe Ausdehnung einer Fördervorrichtung zu erreichen, wobei der Aufwand reduziert werden soll.

Die Aufgabe wird erfindungsgemäß gelöst durch eine Motorsteuerungsvorrichtung für wenigstens einen Antrieb einer Fördervorrichtung, insbesondere einen Kleinspannungsantrieb. Die Motorsteuerungsvorrichtung hat eine Niederspannungsversorgungsschnittstelle zur direkten Anbindung der Motorsteuerungsvorrichtung an eine Niederspannungsleitung. Dabei ist die Niederspannungsvorrichtungsschnittstelle mittels Durchdringungstechnik ausgebildet, sodass die Anbindung an die Niederspannungsleitung unterbrechungsfrei erfolgt.

Ferner wird die Aufgabe erfindungsgemäß durch ein System gelöst, mit einer Niederspannungsleitung und wenigstens einer Motorsteuerungsvorrichtung für wenigstens einen Antrieb einer Fördervorrichtung vor, wobei die wenigstens eine Motorsteuerungsvorrichtung mittels Durchdringungstechnik mit der Niederspannungsleitung verbunden ist. Somit ist eine unterbrechungsfreie Anbindung der Motorsteuerungsvorrichtung an die Niederspannungsleitung gegeben, wobei die Niederspannungsleitung eine Niederspannung oberhalb einer Kleinspannung führt.

Der Grundgedanke der Erfindung ist es, die Motorsteuerungsvorrichtung bzw. den Motor-Controller direkt mit Niederspannung zu versorgen, wozu die Motorsteuerungsvorrichtung die Niederspannungsversorgungsschnittstelle hat. Hierdurch werden die Vorteile einer Niederspannungsversorgung aufrechterhalten, die es ermöglichen, mehrere Antriebe über eine Versorgungsleitung zu versorgen, sodass die Anzahl der parallelen Versorgungsstränge minimiert werden kann, insbesondere sogar ganz vermieden werden kann. Durch die Verbindung der Motorsteuerungsvorrichtung mit der Niederspannungsleitung mittels der Durchdringungstechnik kommt es darüber hinaus zu keinem Leistungsverlust aufgrund von Übergangswiderständen in einem Strang, also im Bereich der elektrischen Anbindung, wodurch die maximale Ausdehnung der Fördervorrichtung bzw. des Systems gewährleistet ist. Die Anzahl an Antrieben, die an der Niederspannungsleitung angeschlossen sind, kann somit weiter erhöht werden.

Das System erlaubt also eine höhere Ausdehnung einer Intralogistikanlage, ohne dass eine zusätzliche Niederspannungsversorgung parallel geführt werden muss oder Absicherungen gesetzt werden müssen.

Insbesondere handelt es sich bei den Antrieben um einen Kleinspannungsantrieb, also einen Antrieb der mit einer Kleinspannung betrieben bzw. mit einer Kleinspannung versorgt wird. Konkret kann es sich bei den Antrieben um Rollenmotoren, Gurttrommelmotoren oder externe Kleinantriebe handeln, die genutzt werden, um Rollen der Fördervorrichtung anzutreiben.

Grundsätzlich handelt es sich bei einer Kleinspannung um eine Spannung bis zu 50 Volt Wechselspannung (VAC) oder 120 Volt Gleichspannung (VDC).

Die Antriebe können also mit einer Spannung bis zu 50 Volt Wechselspannung (VAC) oder 120 Volt Gleichspannung (VDC) versorgt sein, wohingegen die Motorsteuerungsvorrichtung über die Niederspannungsversorgungsschnittstelle direkt mit einer Niederspannung versorgt ist. Die Niederspannung liegt oberhalb der Kleinspannung.

Demnach werden die Motorsteuerungsvorrichtung, die mit der Niederspannung versorgt ist, und der von der Motorsteuerungsvorrichtung angesteuerte Antrieb, der mit der Kleinspannung versorgt ist, mit unterschiedlichen Spannungen betrieben.

Neben der Niederspannungsversorgungsschnittstelle, über die die Motorsteuerungsvorrichtung mit der Niederspannungsleitung zum Erhalt einer Niederspannung verbunden ist, weist die Motorsteuerungsvorrichtung zudem noch wenigstens eine Ausgangsschnittstelle für den Antrieb auf, insbesondere eine Kleinspannung-Ausgangsschnittstelle, über die der Antrieb mit der Kleinspannung versorgt wird.

Dabei ist es vorteilhaft, wenn die Ausgangsspannung variabel ist, um damit die Drehzahl des Motors zu regeln. Außerdem ist es vorteilhaft, wenn die Polarität der Ausgangsspannung gedreht werden kann, um so die Drehrichtung des Motors zu ändern.

Des Weiteren kann die Ausgangsschnittstelle über eine Überwachungsfunktion verfügen, insbesondere eine Stromüberwachung. Außerdem kann die Ausgangsschnittstelle eine oder mehrere Kommunikationsschnittstellen umfassen, die insbesondere dazu ausgelegt sind, den Motor zu steuern oder den Drehwinkel und/oder die Drehgeschwindigkeit des Motors auszulesen.

Um eine höhere Genauigkeit in Bezug auf den Drehwinkel und die Drehgeschwindigkeit des Motors zu erlangen, kann die Anschlussschnittstelle zum Anschluss von Schrittmotoren ausgestaltet sein.

Gemäß einem Aspekt der Erfindung hat die Motorsteuerungsvorrichtung wenigstens eine Gleichstromausgangsschnittstelle, die eingerichtet ist, mit dem wenigstens einen Antrieb der Fördervorrichtung verbunden zu werden. Die Ausgangsschnittstelle, insbesondere die Kleinspannung-Ausgangsschnittstelle, ist also als Gleichstromausgangsschnittstelle ausgebildet, sodass der Antrieb mit einer Gleichspannung versorgt wird.

Ebenso kann die Niederspannungsleitung eine Gleichspannung als Versorgungsspannung zur Verfügung stellen, sodass auch die Motorsteuerungsvorrichtung mit einer Niederspannung versorgt wird. Insofern muss die Motorsteuerungsvorrichtung keinen integrierten AC/DC-Wandler aufweisen.

Es kann jedoch vorgesehen sein, dass ein AC/DC-Wandler der Fördervorrichtung vorgeschaltet ist, wobei von dem AC/DC-Wandler aus die Niederspannungsleitung abgeht.

Die Verwendung einer DC-Niederspannungsversorgung ermöglicht eine einfache Rückspeisung von Bremsenergie, also einer Rekuperation von Energie, wodurch die Effizienz einer Fördervorrichtung verbessert werden kann. Die Rückspeisung kann in das DC-Netz, also das Versorgungsnetz, erfolgen, um so an anderer Stelle verbraucht zu werden. Alternativ oder ergänzend kann die rückgespeiste Energie zwischengespeichert werden.

Des Weiteren erlaubt die Gleichspannungsversorgung die Einbindung in ein DC-Microgrid. Auch können so in einfacher Weise, alternative Energien für die Versorgung verwendet werden, beispielsweise Solarenergie bzw. in Batterien zwischengespeicherte Energie.

In einer bevorzugten Ausführungsform ist die Niederspannungsversorgungsschnittstelle auf eine Niederspannung oberhalb einer Kleinspannung ausgelegt, wobei die Kleinspannung bis zu 50 V Wechselspannung oder 120 V Gleichspannung beträgt. Besonders bevorzugt ist die Niederspannung auf eine Nennspannung von 500 V bis 800 V Gleichspannung, insbesondere eine Nennspannung von 600 V Gleichspannung, oder eine Nennspannung von 100 V bis 400 V Wechselspannung ausgelegt, insbesondere 240 V Wechselspannung. Wie vorstehend bereits erläutert, wird aufgrund der Niederspannung eine höhere Leistung bei gleichen Installationsbedingungen bereitgestellt, wodurch eine größere Anzahl an Antrieben versorgt werden kann.

Es kann vorgesehen sein, dass die Motorsteuerungsvorrichtung wenigstens eine Kommunikationsschnittstelle, insbesondere einen Feldbusanschluss, und/oder wenigstens einen Sensoranschluss aufweist. Der Sensoranschluss kann dabei als ein IO-Link ausgeführt sein. Die Kommunikationsschnittstelle ermöglicht eine Kommunikation mit der Motorsteuerungsvorrichtung. Insbesondere kann die Motorsteuerungsvorrichtung einen als Feldbuseingang ausgebildeten Feldbusanschluss sowie einen als Feldbusausgang ausgebildeten Feldbusanschluss aufweisen. Hierdurch ist einfache und schnelle Verbindung verschiedener Motorsteuerungsvorrichtungen miteinander möglich, sodass auch ein Datenaustausch zwischen den Motorsteuerungsvorrichtungen stattfinden kann. Dies ist insbesondere dann wichtig, wenn mehrere erfindungsgemäße Motorsteuerungsvorrichtungen innerhalb des Systems bzw. der Fördervorrichtung verwendet werden. Bei dem Feldbus kann es sich um einen Ethernet-basierten Feldbus handeln, beispielsweise ProfiNet, Ethernet/IP, OPC/UA FLC.

Über den wenigstens einen Sensoranschluss kann ein Sensor angeschlossen werden, um Informationen über den Sensor zu erhalten und weiterzuverarbeiten, insbesondere auszutauschen. Der Sensoranschluss kann auf einer AS-Schnittstelle (Actuator-Sensor-Interface - "ASI") basieren, also einem Standard für Feldbus-Kommunikation.

Alternativ kann der Sensoranschluss als ein IO-Link ausgeführt sein oder für digitale Sensoren, insbesondere zum Beschreiben des genauen HI-/LO-Signal Verhaltens, also nach dem Verhalten der Norm IEC-61131, ausgeführt sein.

Die Motorsteuerungsvorrichtung umfasst einen Grundkörper sowie einen separat zum Grundkörper ausgebildeten Durchdringungsadapter, der dafür vorgesehen ist, die Niederspannungsleitung zu durchdringen. Somit ist auch beim Abheben des Grundkörpers die Berührungssicherheit hergestellt, da der spannungsführende Teil nicht offenliegt. Dementsprechend können die Grundkörper auch während dem Betrieb abgenommen werden.

Außerdem wird durch die Verwendung eines separaten Durchdringungsadapters das genaue Platzieren und somit das Anschließen der Motorsteuerungsvorrichtung an die Niederspannungsleitung erleichtert. Ein einfacheres Anschließen an die Niederspannungsleitung ist somit möglich, da zunächst nur der Adapter für die genaue Positionierung und das Durchdringen der Leitung benutzt werden kann, woraufhin der Grundkörper anschließend auf den Durchdringungsadapter aufgesetzt werden kann.

Des Weiteren erlaubt es der Adapter, die Niederspannungsleitung auch unter Spannung zu durchdringen, sodass das System im laufenden Betrieb erweitert werden kann. Dafür stellt der Adapter die notwendigen Abstände, die ein berührungssicheres Installieren ermöglichen, bereit, wobei die Kontakte des Durchdringungsadapters ebenfalls berührungssicher ausgebildet sind.

Zudem ist die Motorsteuerungsvorrichtung aufgrund des Adapters anpassbar ausgebildet, da die Motorsteuerungsvorrichtung grundsätzlich mit verschiedenen Arten an Niederspannungsleitungen gekoppelt werden kann, insbesondere hinsichtlich des Durchmessers und/oder der Form der Niederspannungsleitung. Es muss lediglich der passende Adapter gewählt werden, um die Niederspannungsleitung durchdringen zu können. Der Adapter weist eine einheitliche Schnittstelle auf, über die der Adapter elektrisch mit einer Aufnahme am Grundkörper gekoppelt wird.

Der Grundkörper weist eine Aufnahme für den Durchdringungsadapter auf, wobei die Aufnahme und/oder der Durchdringungsadapter gemäß dem Poka-Yoke-Prinzip ausgebildet sind bzw. ist, sodass der Durchdringungsadapter nur in einer definierten Weise von der Aufnahme aufnehmbar ist. In der Aufnahme im Grundkörper kann die Eingangsschnittstelle vorgesehen sein, über die der Adapter elektrisch angebunden ist. Zudem kann der Adapter so ausgebildet sein, dass die Niederspannungsleitung nur in definierter Weise mittels der Durchdringungstechnik durchdrungen wird. Dies ist insbesondere dann wichtig, wenn die Niederspannungsleitung unsymmetrisch ausgebildet ist. Das Poka-Yoke-Prinzip stellt sicher, dass die Niederspannungsleitung verpolungssicher bzw. polrichtig durchdrungen wird, und dass der Adapter und der Grundkörper verpolungssicher bzw. polrichtig miteinander gekoppelt werden.

Die Motorsteuerungsvorrichtung weist weiterhin eine Basis auf, die eine Führung für die Niederspannungsleitung hat. Auch ist die Basis mit dem Grundkörper koppelbar. Durch diese Ausgestaltung der Motorsteuerungsvorrichtung wird der direkte Anschluss an die Niederspannungsleitung erleichtert und das Durchdringen dieser vereinfacht. Durch die vorgegebene Führung der Niederspannungsleitung kann ein ungewolltes falsches Durchdringen, welches potenzielle Gefahren birgt, vermieden werden. Insbesondere kann die Führung an der Basis so ausgestaltet sein, dass die Niederspannungsleitung nur in einer definierten Weise aufgenommen werden kann. Die Basis kann ebenfalls gemäß dem Poka-Yoke-Prinzip ausgebildet sein, sodass die Niederspannungsleitung nur in einer bestimmten Weise von der Basis aufgenommen und/oder der Durchdringungsadapter nur in einer vordefinierten Weise mit der Basis gekoppelt werden kann. Die Führung kann zudem mit dem Durchdingungsadapter zusammenwirken, um die Niederspannungsleitung zu durchdringen.

Der Durchdingungsadapter kann mit der Basis gekoppelt werden, um hierdurch gleichzeitig die durchdrungene Niederspannungsleitung mechanisch zu sichern, beispielsweise zu klemmen.

Die Basis und/oder der Durchdingungsadapter sind bzw. ist derart ausgebildet, dass die Niederspannungsleitung ein Rundleiter oder eine Flachbandleitung sein kann, insbesondere mit unterschiedlichem Durchmesser oder Größe. Der Grundkörper kann unabhängig von der Art der Niederspannungsleitung verwendet werden, da allenfalls eine Anpassung der Basis und/oder des Durchdingungsadapters erfolgen muss.

Bei der verwendeten Niederspannung handelt es sich bevorzugt um eine Gleichspannung, insbesondere eine Gleichspannung von 500 bis 800 V, bevorzugt 600 V. Die Verwendung einer solchen Gleichspannung ermöglicht, wie vorstehend bereits erläutert, eine zukünftige Anschließung des Systems an ein DC-Microgrid sowie die Verwendung alternativer Energien, insbesondere Solarenergien. Auch erleichtert die Verwendung einer DC-Niederspannung das Rückspeisen von Förderenergien in das DC-Netz. Alternativ kann das System aber auch mit einer Wechselspannung im Niederspannungsbereich betrieben werden.

Gemäß einer Ausführungsform weist das System wenigstens ein Anbindungsmodul auf, das separat zur Motorsteuerungsvorrichtung ausgebildet ist. Dabei ist das wenigstens eine Anbindungsmodul direkt mit der Niederspannungsleitung mittels Durchdringungstechnik verbunden. Zudem ist das wenigstens eine Anbindungsmodul mit der wenigstens einen Motorsteuerungsvorrichtung verbunden, um diese mit der Versorgungsspannung zu versorgen. Insbesondere ist vorgesehen, dass jeder Motorsteuerungsvorrichtung ein Anbindungsmodul zugeordnet ist. Diese Ausgestaltung erlaubt eine höhere Flexibilität in der Gestaltung der Intralogistikanlage. Durch die separaten Anbindungsmodule müssen die Motorsteuerungsvorrichtungen nicht direkt auf der Niederspannungsleitung befestigt sein, sondern können stattdessen durch die Anbindungsmodule einen direkten Kontakt zu der Niederspannungsversorgung haben. Insbesondere lassen sich die Motorsteuerungsvorrichtungen an Orten platzieren, die leicht zugänglich sind, wobei die Niederspannungsleitung trotzdem nicht offen zugänglich ist.

Grundsätzlich stellt das Anbindungsmodul demnach sicher, dass die wenigstens eine Motorsteuerungsvorrichtung mittels Durchdringungstechnik mit der Niederspannungsleitung verbunden ist, nämlich indirekt.

Sofern kein Anbindungsmodul vorgesehen ist, kann die wenigstens eine Motorsteuerungsvorrichtung direkt mittels Durchdringungstechnik mit der Niederspannungsleitung verbunden sein. Die Motorsteuerungsvorrichtung hat hierzu die Niederspannungsversorgungsschnittstelle, mit der die direkte Anbindung der Motorsteuerungsvorrichtung an die Niederspannungsleitung erfolgt.

Ein weiterer Aspekt der Erfindung sieht vor, dass das System mehrere Motorsteuerungsvorrichtungen, die jeweils mit der Niederspannungsleitung mittels Durchdringungstechnik verbunden sind, und/oder mehrere Antriebe pro Motorsteuerungsvorrichtung umfasst, insbesondere 4 Antriebe pro Motorsteuerungsvorrichtung. Das erfindungsgemäße System erlaubt also die Versorgung einer ganzen Fördervorrichtung über eine einzige Niederspannungsleitung, ohne dass weitere separate Leitungen und/oder Absicherungen benötigt werden.

Bevorzugt umfasst das System, beispielsweise die Fördervorrichtung, insgesamt mehr als 15 Antriebe.

Ein weiterer Aspekt der Erfindung sieht vor, dass das System wenigstens einen Pufferkondensator umfasst, der eingerichtet ist, Rekuperationsenergien zwischenzuspeichern. Dadurch können Energiekosten gesenkt werden, weil rückgespeiste Bremsenergie zwischengespeichert und zu einem späteren Zeitpunkt verwendet werden kann. Der Pufferkondensator kann in der Motorsteuerungsvorrichtung integriert sein. Auch ist es denkbar, dass der Pufferkondensator separat zur Motorsteuerungsvorrichtung ausgebildet ist.

Alternativ kann die rückgespeiste Energie direkt durch andere Motoren weiterverwendet werden.

Gemäß einer bevorzugten Ausführungsform ist die Niederspannungsleitung als eine Flachbandleitung und/oder ein Hybridkabel zur gleichzeitigen Spannungs- und Datenversorgung ausgebildet. Durch das Vereinen der Spannungs- und Datenversorgung werden weniger einzelne Leitungen benötigt, was die Installation und Wartung der Anlage vereinfacht. Die Flachbandleitungen sind besonders geeignet für die Durchdringungstechnik, da die Position der einzelnen Adern mechanisch exakt bestimmt werden kann, wodurch diese durch die Durchdringungsstifte exakt kontaktiert werden können. Des Weiteren ist durch die unsymmetrische Ausgestaltung der Leitung auch die Polarität der einzelnen Adern bei dem Durchdringen der Vorrichtung eindeutig.

Da Flachbandleitungen jedoch Spezialleitungen sind und dadurch teuer sein können, ist selbstverständlich auch eine Verwendung von Rundleitungen möglich. Beim Verwenden von Rundleitungen und der Kontaktierung mittels der Durchdringungstechnik ist vorzugweise zunächst vorgesehen, dass die Leitung abgemantelt wird, also die äußere Isolation entfernt wird, um die einzelnen Adern der Leitung durchdringen zu können.

Alternativ kann die Niederspannungsleitung gleichzeitig als eine Datenleitung ausgebildet sein, sodass eine Datenübertragung auf die Spannungsversorgung aufmoduliert ist. Auch hierdurch reduziert sich die Anzahl der benötigten Kabel, sodass die Installation und der Aufbau übersichtlicher werden. Dies wird allgemein als Powerline-Technologie bezeichnet. Ein entsprechender Injektor kann vorgesehen sein, über den die Daten aufmoduliert werden. Der Injektor kann Teil eines AC/DC-Wandlers oder grundsätzlich als separates Bauteil ausgebildet sein.

Die wenigstens eine Motorsteuerungsvorrichtung kann eine Adressierung aufweisen. Dies kann für die Kommunikation mittels der Feldbus-Technologie genutzt werden. Die Adresse kann an der Motorsteuerungsvorrichtung selbst eingestellt sein, beispielsweise über eine Programmierschnittstelle oder einen Codierschalter, sodass eine flexible Adressierung möglich ist.

Alternativ kann eine Adressierung dadurch erfolgen, dass die wenigstens eine Motorsteuerungsvorrichtung an einer definierten Position im System vorgesehen ist, insbesondere an einer bestimmten Position der Fördervorrichtung. Die wenigstens eine Motorsteuerungsvorrichtung kann dann eine feste Adresse haben, die einer bestimmten Position zugeordnet ist. Beispielsweise identifiziert ein Gerät sein benachbartes Gerät, da die Geräte in einer Kette eindeutigen Positionen zugeordnet sind.

Auch kann die Adresse (maschinen-)lesbar an der wenigstens einen Motorsteuerungsvorrichtung vorgesehen sein, beispielsweise in Form eines QR-Codes oder eines RFID-Tags. Dabei ist jeder Motorsteuerungsvorrichtung eine spezifische und eindeutige ID (UID: unique ID) zugeordnet, welche einer logischen Adresse entspricht. Diese logische Adresse entspricht wiederum einer physischen Position in dem System. Die jeweilige Zuordnung kann über ein separates Gerät erfolgen, beispielsweise einem Computer oder einem Smartphone.

Grundsätzlich kann es sich bei der Adresse um eine Macadresse in einem Ethernet-basierenden System handeln.

Sofern die Position der wenigstens einen Motorsteuerungsvorrichtung nicht bekannt ist oder diese flexibel ist, kann vorgesehen sein, dass eine Positionsmessung erfolgt, beispielsweise mittels einer Laufzeitmessung, bei der Signallaufzeit eines Signals von einem Sender zur Motorsteuerungsvorrichtung gemessen wird.

Grundsätzlich kann vorgesehen sein, dass die wenigstens eine Motorsteuerungsvorrichtung sich bei einem Kommunikationsaufbau eigenständig identifiziert, indem Adressinformationen übermittelt werden.

Weitere Merkmale und Vorteile der Erfindung ergeben sich aus der nachfolgenden Beschreibung sowie aus den Zeichnungen, auf die Bezug genommen wird. In den Zeichnungen zeigen:
- Figur 1 ein erfindungsgemäßes System mit einer erfindungsgemäßen Motorsteuerungsvorrichtung in einer Explosionsansicht, wobei das System eine als Flachbandleitung ausgebildete Niederspannungsleitung aufweist;
- Figur 2 ein erfindungsgemäßes System mit einer alternativen Ausführungsform der erfindungsgemäßen Motorsteuerungsvorrichtung in einer Explosionsansicht, wobei statt der Flachbandleitung eine Rundleitung vorgesehen ist;
- Figur 3 eine Fördervorrichtung, die ein erfindungsgemäßes System mit einer erfindungsgemäßen Motorsteuerungsvorrichtung für Antriebe der Fördervorrichtung umfasst;
- Figur 4 ein erfindungsgemäßes System mit mehreren Motorsteuerungsvorrichtungen, wobei Anbindungsmodule zur Anbindung an die Niederspannungsleitung verwendet werden;
- Figur 5 eine in der Intralogistik verwendete Fördervorrichtung, das das in Figur 4 gezeigte erfindungsgemäße System aufweist; und
- Figur 6 der Aufbau eines erfindungsgemäßen Systems mit einer aufmodulierter Datenversorgung.

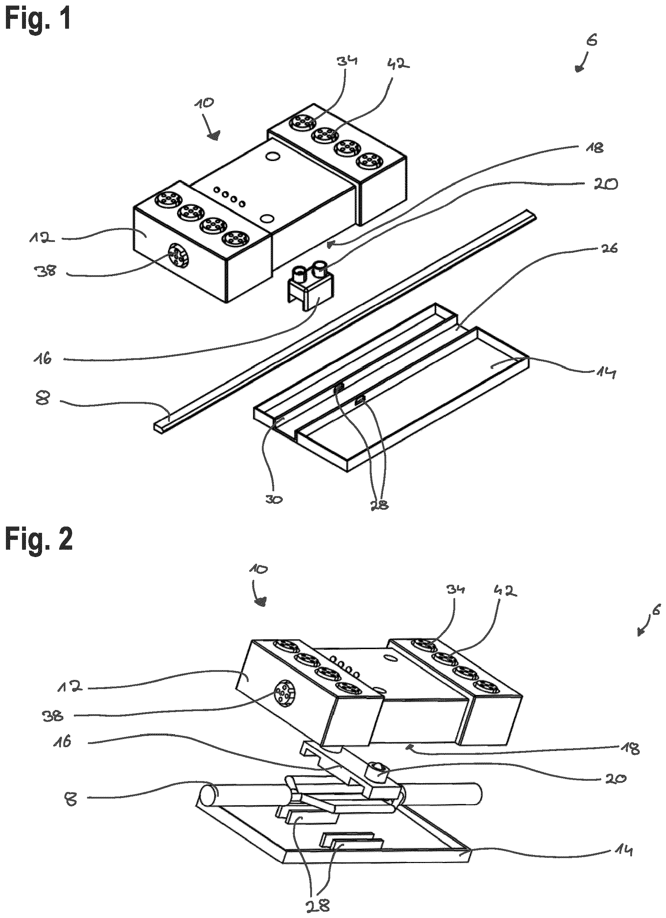

Figur 1 zeigt ein erfindungsgemäßes System 6 mit einer Niederspannungsleitung 8 und einer erfindungsgemäßen Motorsteuerungsvorrichtung 10, welche mit der Niederspannungsleitung 8 gekoppelt werden kann.

Die Motorsteuerungsvorrichtung 10 weist einen Grundkörper 12, eine Basis 14, und einen Durchdringungsadapter 16 auf.

Der Grundkörper 12 und die Basis 14 sind dabei derart ausgebildet, dass sie miteinander gekoppelt werden können, sodass eine lösbare mechanische Verbindung zwischen dem Grundkörper 12 und der Basis 14 erhalten werden kann.

Im zusammengebauten Zustand ist der Durchdringungsadapter 16 vom Grundkörper 12 aufgenommen, der hierzu insbesondere haubenförmig ausgebildet ist und eine Aufnahme 18 hat, mit dem der Durchdringungsadapter 16 über eine Schnittstelle 20 angebunden werden kann.

Die Aufnahme 18 und/oder die Schnittstelle 20 können nach dem Poka-Yoke-Prinzip ausgebildet sein, sodass der Durchdringungsadapter 16 nur in einer definierten Weise von der Aufnahme 18 aufgenommen werden kann.

Die Niederspannungsleitung 8 ist in der gezeigten Ausführungsform als eine Flachbandleitung ausgebildet, mit der die Motorsteuerungsvorrichtung 10 mittels des Durchdringungsadapters 16 direkt angebunden wird.

Insofern stellt in dieser Ausführungsform der Durchdringungsadapter 16 eine Niederspannungsversorgungsschnittstelle 22 der Motorsteuerungsvorrichtung 10 dar, über die die Motorsteuerungsvorrichtung 10 direkt mit der Niederspannungsleitung 8 mithilfe der Durchdringungstechnik elektrisch angebunden wird. Insofern erfolgt die Anbindung an die Niederspannungsleitung 8 unterbrechungsfrei.

Die Basis 14 weist eine Führung 26 auf, die die Niederspannungsleitung 8 aufnimmt.

Des Weiteren sind Klemmstellen 28 an Seitenwänden 30 der Führung 26 vorgesehen, über die der Durchdringungsadapter 16 klemmend von der Führung 26 der Basis 14 gehalten werden kann.

Die Basis 14 und der Durchdringungsadapter 16 können ebenfalls nach dem Poka-Yoke-Prinzip ausgebildet sein, sodass der Durchdringungsadapter 16 nur in einer bestimmten Weise mit der Basis 14 gekoppelt werden kann, insbesondere den Klemmstellen 28.

Die Anbindung der Motorsteuerungsvorrichtung 10 an die Niederspannungsleitung 8 erfolgt, indem zunächst die Niederspannungsleitung 8 in die Führung 26 der Basis 14 positioniert wird. Anschließend wird der Durchdringungsadapter 16 an der richtigen Stelle angesetzt. Wird Druck auf den Durchdringungsadapter 16 ausgeübt, so durchdringt der Durchdringungsadapter 16 die Niederspannungsleitung 8, wodurch ein direkter elektrischer Kontakt zwischen der Motorsteuerungsvorrichtung 10 und der Niederspannungsleitung 8 hergestellt ist, nämlich über den Durchdringungsadapter 16. Gleichzeitig wird der Durchdringungsadapter 16 in der Führung 26 mittels der Klemmstellen 28 klemmend gehalten, sodass dieser nicht unbeabsichtigt gelöst wird. Abschließend wird der Grundkörper 12 auf die Basis 14 aufgesetzt, wobei die Aufnahme 18 im Grundkörper 12 mit der Schnittstelle 20 der Basis 14 koppelt, indem der Grundkörper 12 den Durchdringungsadapter 16 aufnimmt.

Die Niederspannungsleitung 8 kann aufgrund des Durchdringungsadapters 16 auch dann durchdrungen werden, wenn die Niederspannungsleitung 8 unter Spannung steht. Hierzu weist der Durchdringungsadapter 16 berührungssichere Kontakte auf, die so gesetzt sind, dass sie die notwendigen Abstände zum Durchdringen der richtigen Adern der als Flachbandleitung ausgebildeten Niederspannungsleitung 8 haben. Dies ist insbesondere dadurch möglich, dass die Positionen der einzelnen Adern in der Flachbandleitung mechanisch exakt bestimmt sind.

In Figur 2 ist eine alternative Ausführungsform gezeigt, bei der die Niederspannungsleitung 8 als eine Rundleitung ausgebildet ist.

Insofern ist der Durchdringungsadapter 16 anders ausgestaltet, um die als Rundleitung ausgebildete Niederspannungsleitung 8 mittels Durchdringungstechnik elektrisch zu kontaktieren.

Insbesondere wird die als Rundleitung ausgebildete Niederspannungsleitung 8 zunächst teilweise abisoliert bzw. abgemantelt, um die einzelnen Adern freizulegen, die dann mittels des Durchdringungsadapters 16 kontaktiert werden.

Diese Ausführungsvariante unterscheidet sich von der vorherigen Variante insofern, dass die Klemmstellen 28 nicht an Seitenwänden einer Führung ausgebildet sind, sondern durch Vorsprünge, auf die der Durchdringungsadapter 16 aufgesetzt wird.

Die Klemmstellen 28 können zudem als Doppelvorsprünge ausgebildet sein, sodass die einzelnen Adern der als Rundleitung ausgebildeten Niederspannungsleitung 8 sicher positioniert werden können, um gleichzeitig ein richtiges Positionieren des Durchdringungsadapters 16 zu gewährleisten.

In der gezeigten Ausführungsvariante weist der Durchdringungsadapter 16 eine anders ausgebildete Schnittstelle 20 im Vergleich zur ersten Ausführungsvariante auf.

Es kann vorgesehen sein, dass die Durchdringungsadapter 16 stets eine einheitliche Schnittstelle haben, sodass diese mit demselben Grundkörper 12 verwendet werden können.

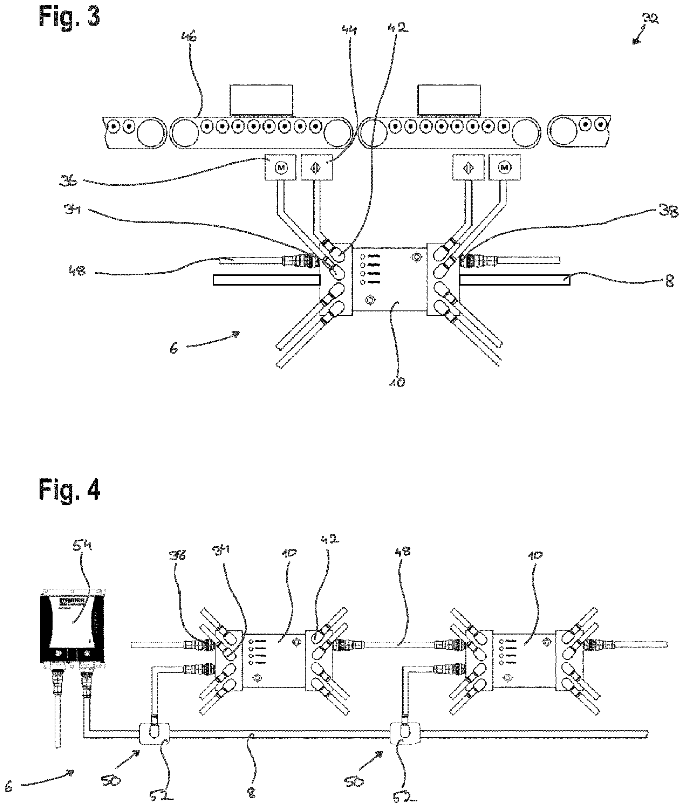

Zur Einbindung in eine Fördervorrichtung 32, welche in Figur 3 gezeigt ist, weist die Motorsteuerungsvorrichtung 10 zudem noch eine Ausgangsschnittstelle 34 für einen Antrieb 36, einen Kommunikationsanschluss 38, insbesondere einen Feldbusanschluss, sowie einen Sensoranschluss 42 für einen Sensor 44 auf.

Bei dem Antrieb 36 handelt es sich insbesondere um einen Kleinspannungsantrieb, also einen Antrieb der mit einer Kleinspannung betrieben bzw. mit einer Kleinspannung versorgt wird, also mit einer Spannung bis zu 50 Volt Wechselspannung (VAC) oder 120 Volt Gleichspannung (VDC).

Die Motorsteuerungsvorrichtung 10 ist dagegen an die Niederspannungsleitung 8 angeschlossen, an der eine Niederspannung anliegt, die größer als die Kleinspannung ist, also größer als 50 Volt Wechselspannung (VAC) oder 120 Volt Gleichspannung (VDC). Beispielsweise ist die Niederspannung auf eine Nennspannung von 500 V bis 800 V Gleichspannung, insbesondere 600 V Gleichspannung, oder eine Nennspannung von 100 V bis 400 V Wechselspannung ausgelegt, insbesondere 110 V bzw. 240 V Wechselspannung.

Bei der Niederspannung kann es sich also um eine Gleichspannung handeln, sodass die Ausgangsschnittstelle 34 für so ausgebildet ist, dass sie den Antrieb 36 der Fördervorrichtung 32 mit Gleichspannung versorgt.

Aus Figur 3 wird deutlich, dass die Fördervorrichtung 32 das System 6 aufweist, welches die Niederspannungsleitung 8 sowie wenigstens eine Motorsteuerungsvorrichtung 10 umfasst, an der mehrere Antriebe 36 über die entsprechenden Ausgangsschnittstellen 34 angeschlossen sind.

Die Fördervorrichtung 32 umfasst außerdem Rollenbahnen 46, die von den Antrieben 36 angetrieben werden. Wie in Figur 3 gezeigt, hat jede Rollenbahn 46 ihren eigenen Antrieb 36 sowie einen eigenen Sensor 44.

Die Sensoren 44 können grundsätzlich den Zustand der Fördervorrichtung 32 überwachen, insbesondere von Komponenten der Fördervorrichtung 32.

Die Ansteuerungsbefehle erhält die Motorsteuerungsvorrichtung 10 über den Kommunikationsanschluss 38. Auch können über den Kommunikationsanschluss 38 Informationen der Sensoren 44 weitergeleitet werden.

Insofern ist an dem Kommunikationsanschluss 38 eine Datenleitung 48 angeschlossen, insbesondere eine Feldbusleitung.

Hierzu können mit dem Feldbus weitere Motorsteuerungsvorrichtungen 10 angeschlossen sein, sodass eine Kommunikation unter den Motorsteuerungsvorrichtungen 10 über den Feldbus erfolgt. Die Motorsteuerungsvorrichtungen 10 weisen hierzu insbesondere einen als Feldbuseingang ausgebildeten Kommunikationsanschluss 38 sowie einen als Feldbusausgang ausgebildeten Kommunikationsanschluss 38 auf.

Typischerweise werden Ethernet-basierte Feldbusse benutzt. Alternativ oder ergänzend kann eine Aktor-/Sensorschnittstelle (ASI) zum Einsatz kommen.

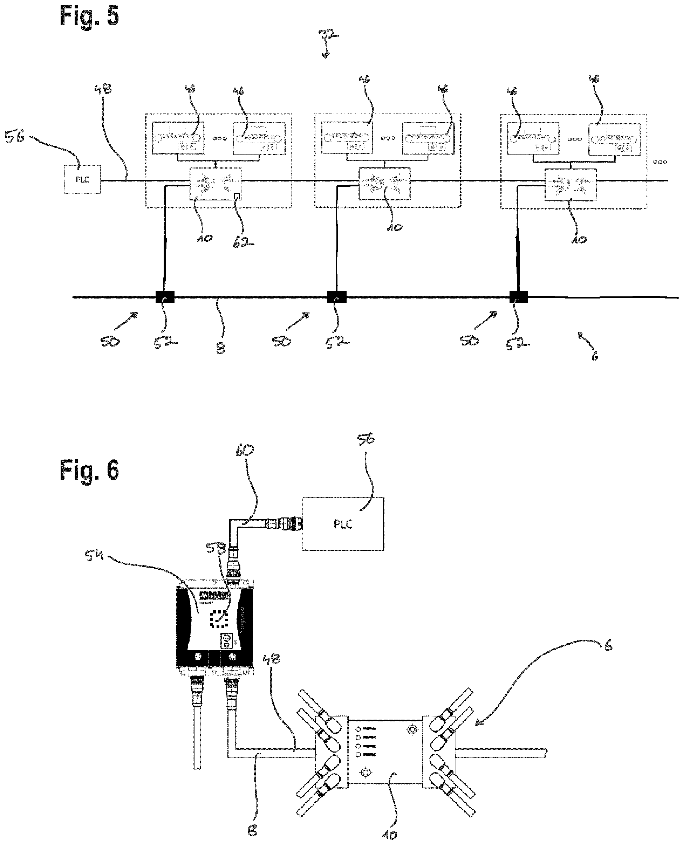

In der in Figuren 4 und 5 gezeigten Ausführungsformen sind die Motorsteuerungsvorrichtungen 10 durch die separate Datenleitung 48, insbesondere die Feldbusleitung, miteinander verbunden. Dies gilt in analoger Weise für die Ausführungsformen nach Figur 3, auch wenn dort nur eine Motorsteuerungsvorrichtung 10 gezeigt ist.

Die Datenleitung 48 wird zur Adressierung einzelner Motorsteuerungsvorrichtungen 10 benötigt. Eine exakte Adressierung ist insbesondere in großen Intralogistikanlagen, wie beispielsweise in Figur 5 dargestellt, notwendig. Hier bestehen einzelne Abschnitte aus jeweils einer Motorsteuerungsvorrichtung 10 sowie mehreren Rollbahnen 46 mit ihren zugehörigen Antrieben 36 und Sensoren 44. Für eine bessere Übersicht sind diese einzelnen Abschnitte durch gestrichelte Kästchen gekennzeichnet.

Es bestehen mehrere Möglichkeiten, die Motorsteuerungsvorrichtung 10 über die Datenleitung 48 zu adressieren. Im einfachsten Fall wird hierbei eine Adresse an der Motorsteuerungsvorrichtung 10 direkt eingestellt. Dies kann über mechanische Schalter, aber auch über eine Programmierschnittstelle geschehen.

Eine weitere Möglichkeit ist es, einer Motorsteuerungsvorrichtung 10 eine bestimmte Position im System 6 bzw. der Fördervorrichtung 32 zuzuordnen, wobei hierzu die Motorsteuerungsvorrichtungen 10 eine feste Adresse haben, die zu einer Position zugeordnet wird. Als Adresse eignet sich beispielsweise die MACAdresse, die in Ethernet-basierten Systemen eindeutig ist. Um die Bedienung zu erleichtern, kann diese Adresse auf der Motorsteuerungsvorrichtung 10 in lesbarer Form aufgedruckt sein oder aber sie kann durch maschinenlesbare Kennzeichnungen, wie QR-Code oder RFID-Tag, abgerufen werden. Bei maschinenlesbaren Kennzeichnungen findet die Zuordnung zwischen Positionen in einem Steuerungsprogramm und der realen Motorsteuerungsvorrichtung 10 mit einem zusätzlichen Gerät statt.

Alternativ kann die Motorsteuerungsvorrichtung 10 auch so ausgelegt sein, dass sie sich selbst identifiziert. Dabei würde die Motorsteuerungsvorrichtung 10 ihre Adresse kommunizieren und sich somit an einer zentralen Steuerung bemerkbar machen.

Ebenso ist es möglich, die Position einer Motorsteuerungsvorrichtung 10 im System 6 zu messen. Die Position der Motorsteuerungsvorrichtung 10 wird dann über Signallaufzeiten zwischen der Signalquelle und der Motorsteuerungsvorrichtung 10 bestimmt, wodurch der Motorsteuerungsvorrichtung 10 eine Position zugeordnet werden kann.

Gemäß einer alternativen Ausführungsform kann die direkte Verbindung der Motorsteuerungsvorrichtung 10 mit der Niederspannungsleitung 8 auch durch ein separat ausgebildetes Anbindungsmodul 50 hergestellt werden, wie dies in den Figuren 4 und 5 gezeigt ist.

Dabei umfasst das Anbindungsmodul 50 den Durchdringungsadapter 16, der in einem separaten Gehäuse 52 des Anbindungsmoduls 50 aufgenommen ist.

Insbesondere ist jeder Motorsteuerungsvorrichtung 10 exakt ein Anbindungsmodul 50 zugeordnet, über das die Motorsteuerungsvorrichtung 10 mit der Niederspannungsleitung 8 elektrisch verbunden ist.

Ebenfalls gezeigt in Figur 4 ist ein AC-/DC-Wandler 54. Dieser ermöglicht eine AC-Stromversorgung für das System 6, indem er den AC-Strom in DC-Strom umwandelt. Somit wird die Motorsteuerungsvorrichtung 10 weiterhin mit Gleichstrom beschrieben.

Parallel zur Spannungsversorgung wird die Datenleitung 48 geführt, über die die Kommunikation unter den Motorsteuerungsvorrichtungen 10 und mit einer zentralen Steuerung 56 erfolgt. In Figur 5 ist die zentrale Steuerung 56 als "Programmable Logic Controller" - PLC bezeichnet, wovon ausgehend die Datenleitung 48 mit den Motorsteuerungsvorrichtungen 10 verbunden ist.

Bei der zentralen Steuerung 56 kann es sich um eine speicherprogrammierbare Steuerung (SPS) handeln. Alternativ zur SPS können auch Industrie-PCs, Edge-Gateways (EGW) oder ein Anschluss an ein anderes Leitsystem verwendet werden.

Gemäß einer Ausführungsform kann die Datenleitung 48 in der Niederspannungsleitung 8 integriert sein, sodass keine separate Datenverbindung benötigt wird. Hierzu kann ein Hybridkabel vorgesehen sein.

Grundsätzlich können in einem großen System 6 bzw. einer großen Fördervorrichtung 32, wie in Figur 5 gezeigt, mehrere Antriebe 36 vorhanden sein, die pro Motorsteuerungsvorrichtung 10 vorgesehen sind. Die Antriebe 36 können dabei parallel geschaltet sein, sodass eine Energieversorgung der mehreren Antriebe 36 über die Antriebe 36 erfolgt.

Gemäß einer alternativen Variante, wie sie in Figur 6 gezeigt ist, kann der AC-/DC-Wandler 54 einen integrierten Powerline-Injektor 58 beinhalten. Alternativ kann der Powerline-Injektor 58 separat zum AC/DC-Wandler 54 vorgesehen sein, insbesondere wenn das System 6 ein Gleichspannungssystem ist, bei dem kein AC/DC-Wandler 54 vorgesehen ist.

Grundsätzlich lässt sich so die Datenübertragung auf die Spannungsversorgung aufmodulieren, sodass die separate Datenleitung 48 nicht benötigt wird. Mit anderen Worten bildet die Niederspannungsleitung 8 dann gleichzeitig die Datenleitung 48 aus, wie dies in Figur 6 gezeigt ist.

Wie in Figur 6 auch zu sehen ist, ist in diesem Fall die zentrale Steuerung 56 über eine Feldbusverbindung 60 mit dem AC-/DC-Wandler 54 verbunden.

Darüber hinaus kann vorgesehen sein, insbesondere wenn das System 6 ein Gleichspannungssystem, dass das System 6 zumindest einen Pufferkondensator 62 umfasst, der eingerichtet ist, rekuperierte Energie zwischenzuspeichern, beispielsweise Bremsenergie. Der Pufferkondensator 62 kann, wie in Figur 5 gezeigt, in der Motorsteuerungsvorrichtung 10 selbst angeordnet sein oder separat hierzu. Grundsätzlich kann der Pufferkondensator 62 in jedem der Komponenten des Systems 6 vorgesehen sein.

## Patentansprüche

1. Motorsteuerungsvorrichtung (10) für wenigstens einen Antrieb einer Fördervorrichtung (32), wobei die Motorsteuerungsvorrichtung (10) eine Niederspannungsversorgungsschnittstelle (22) zur direkten Anbindung der Motorsteuerungsvorrichtung (10) an eine Niederspannungsleitung (8) hat, wobei die Niederspannungsversorgungsschnittstelle (22) mittels Durchdringungstechnik ausgebildet ist, sodass die Anbindung an die Niederspannungsleitung (8) unterbrechungsfrei erfolgt.

2. Motorsteuerungsvorrichtung (10) nach Anspruch 1, **dadurch gekennzeichnet, dass** die Motorsteuerungsvorrichtung (10) wenigstens eine Gleichstrom-Ausgangsschnittstelle hat, die eingerichtet ist, mit dem wenigstens einen Antrieb (36) der Fördervorrichtung (32) verbunden zu werden.

3. Motorsteuerungsvorrichtung (10) nach Anspruch 1 oder 2, **dadurch gekennzeichnet, dass** die Niederspannungsversorgungsschnittstelle (22) auf eine Niederspannung oberhalb einer Kleinspannung ausgelegt ist, wobei die Kleinspannung bis zu 50 Volt Wechselspannung oder 120 Volt Gleichspannung beträgt, bevorzugt auf eine Nennspannung von 500 V bis 800 V Gleichspannung, insbesondere 600 V Gleichspannung, oder eine Nennspannung von 100 V bis 400 V Wechselspannung ausgelegt ist, insbesondere 110 V und 240 V Wechselspannung.

4. Motorsteuerungsvorrichtung (10) nach einem der vorhergehenden Ansprüche, **dadurch gekennzeichnet, dass** die Motorsteuerungsvorrichtung (10) wenigstens einen Kommunikationsanschluss (38), insbesondere einen Feldbusanschluss, und/oder wenigstens einen Sensoranschluss (42) aufweist.

5. Motorsteuerungsvorrichtung (10) nach einem der vorhergehenden Ansprüche, **dadurch gekennzeichnet, dass** die Motorsteuerungsvorrichtung (10) einen Grundkörper (12) und einen zum Grundkörper (12) separat ausgebildeten Durchdingungsadapter (16) umfasst, der eingerichtet ist, die Niederspannungsleitung (8) zu durchdringen.

6. Motorsteuerungsvorrichtung (10) nach Anspruch 5, **dadurch gekennzeichnet, dass** der Grundkörper (12) eine Aufnahme (18) für den Durchdingungsadapter (16) aufweist, wobei die Aufnahme (18) und/oder der Durchdingungsadapter (16) gemäß dem Poka-Yoke Prinzip ausgebildet sind bzw. ist, sodass der Durchdingungsadapter (16) nur in einer definierten Weise von der Aufnahme (18) aufnehmbar ist.

7. Motorsteuerungsvorrichtung (10) nach einem der vorhergehenden Ansprüche, **dadurch gekennzeichnet, dass** die Motorsteuerungsvorrichtung (10) eine Basis (14) aufweist, die eine Führung (26) für die Niederspannungsleitung (8) hat, und wobei die Basis (14) mit dem Grundkörper (12) koppelbar ist.

8. System (6) mit einer Niederspannungsleitung (8) und wenigstens einer Motorsteuerungsvorrichtung (10) für wenigstens einen Antrieb (36) einer Fördervorrichtung (32), insbesondere nach einem der vorhergehenden Ansprüchen, wobei die wenigstens eine Motorsteuerungsvorrichtung (10) mittels Durchdringungstechnik mit der Niederspannungsleitung (8) verbunden ist, sodass die Anbindung der Motorsteuerungsvorrichtung (10) an die Niederspannungsleitung (8) unterbrechungsfrei erfolgt, und wobei die Niederspannungsleitung (8) eine Niederspannung oberhalb einer Kleinspannung führt.

9. System (6) nach Anspruch 8, **dadurch gekennzeichnet, dass** die Niederspannung eine Gleichspannung ist, insbesondere eine Gleichspannung von 500 V bis 800 V, bevorzugt 600 V.

10. System (6) nach Anspruch 8 oder 9, **dadurch gekennzeichnet, dass** das System (6) wenigstens ein Anbindungsmodul (50) aufweist, das separat zur Motorsteuerungsvorrichtung (10) ausgebildet ist, wobei das wenigstens eine Anbindungsmodul (50) direkt mit der Niederspannungsleitung (8) mittels Durchdringungstechnik verbunden ist, und wobei das Anbindungsmodul (50) mit der wenigstens einen Motorsteuerungsvorrichtung (10) verbunden ist, um die Motorsteuerungsvorrichtung (10) mit der Versorgungsspannung zu versorgen, insbesondere wobei jeder Motorsteuerungsvorrichtung (10) ein Anbindungsmodul (50) zugeordnet ist.

11. System (6) nach einem der Ansprüche 8 bis 10, **dadurch gekennzeichnet, dass** das System (6) mehrere Motorsteuerungsvorrichtungen (10), die jeweils mit der Niederspannungsleitung (8) mittels Durchdringungstechnik verbunden sind.

12. System (6) nach einem der Ansprüche 8 bis 10, **dadurch gekennzeichnet, dass** das System (6) mehrere Antriebe (36) pro Motorsteuerungsvorrichtung (10) umfasst, insbesondere vier Antriebe (36) pro Motorsteuerungsvorrichtung (10), insbesondere wobei das System (6) mehr als fünfzehn Antriebe (36) umfasst.

13. System (6) nach einem der Ansprüche 8 bis 12, **dadurch gekennzeichnet, dass** das System (6) wenigstens einen Pufferkondensator (62) umfasst, der eingerichtet ist, rekuperierte Energie zwischenzuspeichern.

14. System (6) nach einem der Ansprüche 8 bis 13, **dadurch gekennzeichnet, dass** die Niederspannungsleitung (8) als eine Flachbandleitung und/oder Hybridkabel zur gleichzeitigen Spannungs- und Datenversorgung ausgebildet ist.

15. System (6) nach einem der Ansprüche 8 bis 14, **dadurch gekennzeichnet, dass** die die Niederspannungsleitung (8) gleichzeitig eine Datenleitung (48) ausbildet, sodass eine Datenübertragung auf die Spannungsversorgung aufmoduliert ist.
